Europäisches Patentamt

European Patent Office

Office européen des brevets

(11) Publication number: **0 388 154**
**A2**

## EUROPEAN PATENT APPLICATION

(21) Application number: 90302671.4

(22) Date of filing: 13.03.90

(51) Int. Cl.⁵: **H01L 31/0376, H01L 31/108, H01L 27/148**

(30) Priority: 13.03.89 JP 60017/89

(43) Date of publication of application:
**19.09.90 Bulletin 90/38**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Miyagaki, Shinji**
**Rose Garden 103, 1-15-3, Fukasawa**
**Setagaya-ku, Tokyo 158(JP)**
Inventor: **Ri, Seigen**
**Bamu-haitsu Kikuna 5-302, 1-30, Kaminomiya**
**Tsurumi-ku, Yokohama-shi, Kanagawa**
**230(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

(54) **Photosemiconductor devices.**

(57) A photosemiconductor device of the type in which light reaching a photosensitive layer (14;27;44) of a doped amorphous semiconductor material, between two electrodes (12,15;23,29;42,46) of the device, generates electron-hole pairs in that layer (14;27;44), the doping of the said amorphous semiconductor material being such that its conductivity is substantially equal to that of the purely intrinsic form of that material, is characterised by a layer (13;26;43) of non-doped amorphous semiconductor material interposed between the said photosensitive layer (14;27;44) and one of the said electrodes (12;23;42).

Preferably, the photosensitive layer (14;27;44) is doped with an acceptor, such as boron.

In such a device the degree of doping of the photosensitive layer can be decided more freely than in prior art devices of the said type.

# Fig.3

# PHOTOSEMICONDUCTOR DEVICES

The present invention relates to photosemiconductor devices.

In such a device, for example a photodiode, light incident upon the device generates electron-hole pairs in a semiconductor layer thereof. The semiconductor layer may be made of an amorphous semiconductor material (for example, silicon).

Amorphous photodiodes are used in a CCD image sensor of a video tape recording (VTR) camera, a linear image sensor of a facsimile machine, or an optical character reader (OCR), a photosensor and the like.

An amorphous photodiode has a transparent electrode/amorphous silicon/metal electrode structure, and detects electric charge signals of electron-hole pairs generated by incident light when a bias voltage is applied between the electrodes.

Owing to the application of a bias voltage to the amorphous photodiode when it is in operation, if electrons or holes are injected into the amorphous Si layer, or electron-hole pairs are generated by thermal energy in an amorphous silicon (Si) layer, a so-called "dark" current is generated even in the absence of incident light. The dark current constitutes noise in a photocurrent signal, and, therefore, it is necessary to reduce the dark current as much as possible.

The amorphous silicon layer of the amorphous photodiode is generally deposited (formed) by a plasma chemical vapour deposition (CVD) method. Although impurities (dopant) are not added during the plasma CVD process, a deposited amorphous silicon layer has an n-type conductivity, and, when the bias voltage is applied, electrons are injected into the amorphous silicon layer, thereby generating a dark current. To reduce the thus-generated dark current, it is necessary to compensate for the n-type conductivity in some way, so as to change the n-type amorphous silicon to an effectively intrinsic semiconductor.

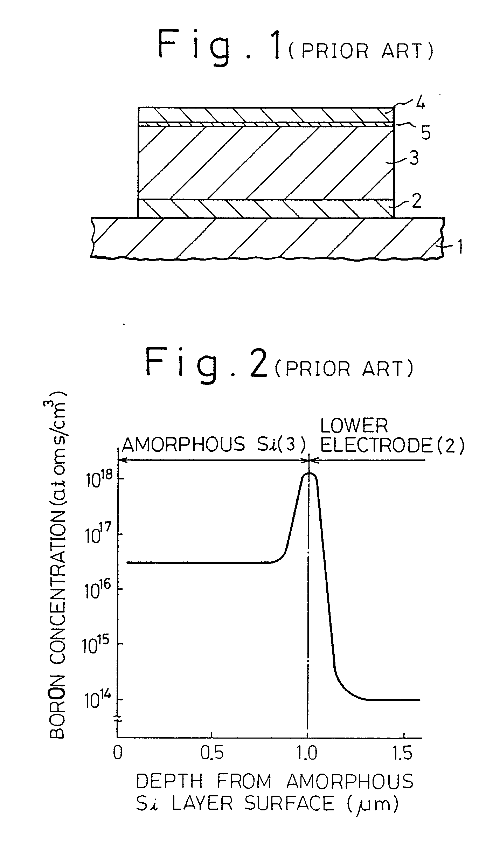

As shown in Fig. 1 of the accompanying drawings, a conventional amorphous photodiode comprises a substrate 1, a lower electrode (electron collecting electrode) 2 of aluminum formed on the substrate 1, an amorphous silicon layer 3 deposited on the lower electrode 2, and an upper electrode (hole collecting electrode) 4 formed on the amorphous layer 3 and serving as a transparent electrode for incident light penetrating the amorphous layer 3. The upper electrode 4 is usually made of indium-tin-oxide (ITO), and between the upper electrode 4 and the amorphous silicon layer 3, a p-type amorphous SiC layer 5 is formed to prevent an interaction therebetween and serves as a hetero-junction barrier (for example, cf. S. KANEKO, et al: "Amorphous Si:H Heterojunction Photodiode and its Application to a Compact Scanner", Mat. Res. Soc. Symp. Proc. Vol. 49, 1985, pp. 423-428). Since the amorphous SiC layer 5 has a low resistivity, is transparent and is relatively thin (15 to 40 nm), the layer 5 is regarded as a part of the upper electrode.

The simplest way to reduce the dark current caused by the n-type amorphous silicon layer is to dope (introduce) p-type impurities (acceptors) into the amorphous silicon layer, to change the conductivity thereof to its intrinsic value. Typically, the amorphous silicon layer 3 is doped with boron (B) during the CVD process by adding an impurity-containing gas, such as diborane ($B_2H_6$), to a raw material gas (for example, cf. R. Miyagawa, et al., "A New Pre-Discharge Boron Doping Method...", 74-IEDM88, IEEE, pp. 74-77).

However, as the dose of boron in the amorphous silicon is increased, local states are generated in a forbidden band and serve as recombination centers of electron-hole pairs. An increase of the recombination of the electron-hole pairs reduces the photocurrent, and thus it is undesirable to generate such local states (trap levels).

The dose (concentration) of boron for making an amorphous silicon intrinsic is generally in the range from 0.1 to 1ppm. The dose value is established by considering the advantageous and disadvantageous effects of boron, such as reduction of the dark current owing to a formation of an intrinsic state and a reduction of the photocurrent due to an increase of generated recombination centers. When a relatively large dose of impurities is introduced into a deposited layer, generally the impurities easily pile up (congregate) at the interface between the deposited layer and an underlying layer of another material. Accordingly, it is predicted that boron atoms doped in the amorphous silicon layer of an amorphous photodiode will pile up at an interface between the doped layer and an electrode. When a boron concentration profile in an amorphous photodiode is actually measured, as shown in Fig. 2 of the accompanying drawings, the pile-up of boron occurs at the interface of the amorphous silicon layer 3 and lower electrode 2. Note, in Fig. 2, the boron concentration in the lower electrode holds a constant value of about $1 \times 10^{14}$ atoms/cm$^3$, but this value is the lower limit value of the measuring instrument used. The inside portion of the electrode does not substantially contain boron. The pile-up of boron near the lower electrode may be caused by a relatively larger and unstable deposition rate of boron at an early stage of a CVD process of depositing an amorphous silicon layer than under a steady stage (state).

When the boron concentration becomes higher than a predetermined value (i.e. a constant value in the amorphous silicon layer shown in Fig. 2), not only is the photocurrent reduced by the recombination of electron-hole pairs, but also the dark current is increased by a generation of defects such as an increased number of dangling bonds, and thus the pile-up of boron causes a lowering of the photodiode properties. Furthermore, the introduction of boron into an amorphous silicon layer deteriorates the layer structure, thereby lowering an adhesion strength thereof to an underlying layer, which tends to lower the photodiode properties. Therefore, in an amorphous photodiode having a structure shown in Fig. 1, the factors reducing the photodiode properties are concentrated in the vicinity of the lower electrode.

Accordingly, it is desirable to provide a photosemiconductor device, such as a photodiode, in which the above-mentioned problems can be avoided, or at least substantially reduced.

According to an embodiment of the present invention there is provided a photosemiconductor device comprising an amorphous intrinsic semiconductor layer which is doped with boron at a dose by which the semiconductor is made intrinsic and in which layer electron-hole pairs are generated by an incident light, and two electrodes (a lower electrode and an upper electrode) holding the semiconductor layer therebetween are supplied with a bias voltage for taking out the generated electric charges, one electrode collecting electrons and another electrode collecting holes, characterized in that an amorphous semiconductor layer not doped with a dopant is formed between the electron collecting electrode (the lower electrode) and the boron-doped amorphous intrinsic semiconductor layer.

In an amorphous photodiode embodying the present invention, since the amorphous silicon layer in which electron-hole pairs are generated is made intrinsic by boron doping, a dark current is reduced in a similar manner to a conventional boron-doped amorphous photodiode. Since the undoped amorphous silicon layer is additionally formed in the vicinity of the electron collecting electrode (the lower electrode) at which a pile-up of boron easily occurs in a conventional amorphous photodiode, it is possible to prevent the occurrence of unfavorable effects caused by the pile-up of boron and to improve the adherence of the amorphous layers to an underlying layer including the electron collecting electrode.

According to an embodiment of the present invention, when a dose (concentration) of boron is set, since it is unnecessary to consider the above-described pile-up and adherence problems, the dose can be freely determined at the most suitable value.

Reference will now be made, by way of example, to the accompanying drawings, in which:

Fig. 1 (described above) shows a schematic cross-sectional view of a conventional amorphous photodiode;

Fig. 2 (described above) is a graph showing a boron concentration distribution profile in such a conventional amorphous photodiode having a doped amorphous silicon layer;

Fig. 3 shows a schematic cross-sectional view of an amorphous photodiode embodying the present invention;

Fig. 4 shows a schematic cross-sectional view of an amorphous photodiode according to a first embodiment of the present invention;

Fig. 5 is a graph showing a boron concentration distribution profile in an amorphous photodiode embodying the present invention;

Figs. 6 and 7 are graphs; and

Fig. 8 shows a schematic cross-sectional view of a CCD image sensor comprising an amorphous photodiode embodying the present invention.

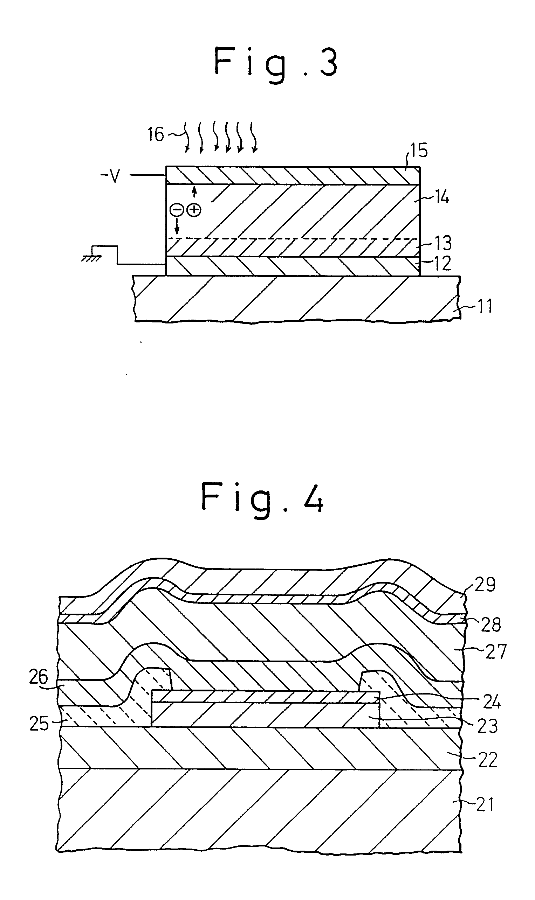

Referring to Fig. 3, a basic amorphous photodiode embodying the present invention comprises an insulating substrate (an underlying layer) 11, a lower electrode 12, an undoped amorphous silicon layer 13, a boron-doped (intrinsic) amorphous silicon layer 14, and an upper electrode 15. A bias voltage is applied across the lower electrode 12 and upper electrode 15 (in this case, the upper electrode 15 is a hole-collecting electrode to which a potential of -V is applied, and the lower electrode 12 is a grounded electron-collecting electrode). When incident light 16 falls on the photodiode, electron-hole pairs are generated in the boron-doped amorphous silicon layer 14, electrons are collected at the lower electrode 12, and holes are collected at the upper electrode 15, so that a photocurrent (signal) flows between the electrodes 12 and 15.

During manufacture of the photodiode, the undoped amorphous silicon layer 13 and the boron-doped amorphous silicon layer 14 are successively deposited on the lower electrode 12 in a plasma CVD apparatus. Dopant material, comprising diborane ($B_2B_6$) gas, is not added to the CVD apparatus during the formation of the undoped amorphous silicon layer 13, but only during the formation of the boron-doped amorphous silicon layer 14. Preferably, the undoped amorphous silicon layer 13 has a thickness in the range from 50 to 500 nm, and in particular in the range from 200 to 400 nm.

Furthermore, preferably, a total thickness of the undoped amorphous silicon layer 13 and the boron-doped amorphous silicon layer 14 is in the range from 1 to 3 um. If the total thickness is less than 1 $\mu$m, the two layers 13 and 14 have an insufficient breakdown voltage, but if the total thickness is more than 3 $\mu$m, the amorphous silicon layers 13 and 14 tend to peel away from the lower electrode 12 due to thermal stress. Note, the incident light generates electron-hole pairs in the undoped amorphous silicon layer 13.

Example 1

Referring to Fig. 4, an amorphous photodiode according to a first embodiment of the present invention comprises a single crystal silicon (Si) substrate 21, a SiO$_2$ insulating layer 22 formed on the substrate 21, an aluminum lower electrode 23 having a predetermined pattern, a TiN barrier layer 24 formed on the surface of the lower electrode 23, a PSG insulating layer 25 isolating the lower electrode 23 from other lower electrodes (not shown), an undoped amorphous silicon layer 26 formed over the whole surface, a boron-doped amorphous silicon layer 27, a p-type amorphous SiC layer 28, and an upper electrode 29 as a transparent layer.

Such an amorphous photodiode is produced in the following manner.

First, the Si substrate 21 is thermally oxidized to form, the SiO$_2$ layer 22 having a thickness of about 1 $\mu$m. It is possible to form a SiN layer or a PSG layer by a CVD method instead of forming the SiO$_2$ layer. Then an aluminum layer 23 having a thickness of 200 nm is deposited on the whole surface of the SiO$_2$ layer 22 by vacuum vapor deposition, and the TiN layer 24 having a thickness of 200 nm is deposited on the aluminum layer 23 by a reactive sputtering method. The TiN layer 24 serves as a barrier to prevent a reaction between the amorphous silicon and aluminum, and may be replaced by WSi, WN, W or the like. A resist layer (not shown) is applied to the TiN layer, exposed, and developed to form a resist pattern mask, and then a portion of the TiN layer 24 not coated with the resist mask is etched off, and the underlying portion of the aluminum layer 23 is etched off, whereby an aluminum layer 23 and TiN layer 24 having a predetermined pattern are formed, as shown in Fig. 4.

The PSG layer 25 is deposited on the whole surface by a CVD method, and is selectively etched in accordance with a conventional photolithography process to form a window exposing the TiN layer 24. The window has, for example, an area of 1 mm x 1 mm. In the case of a CCD image sensor, a lower electrode (pixel electrode) has an area of about 10 $\mu$m x 10 $\mu$m.

Next, an undoped amorphous silicon layer 26 (having a thickness of 50, 100, 200, 400, 600 or 1000 nm) is formed (deposited) over the whole surface by using a plasma CVD apparatus under the following conditions, for example:
Raw material gas: SiH$_4$ (100 SCCM)
Pressure: 1 Torr
Applied RF: 13.56 MHz
Applied power: 20 W
Heating temperature of Si substrate: 280$^\circ$C
In the same CVD apparatus, an amorphous silicon layer is further deposited under the above-mentioned conditions and with an addition of a diborane gas (B$_2$H$_6$: 5 ppm) diluted with a hydrogen (H$_2$) carrier gas at a feed rate of 10 SCCM, so as to form a boron-doped amorphous silicon layer 27 (having a thickness of 1000, 950, 900, 800, 600, or 400 nm, depending upon the thickness of the underlying non-doped layer 26). In this case, the total thickness of the amorphous silicon layers 26 and 27 is 1 $\mu$m. The boron-doped amorphous silicon layer 27 has a boron content (concentration) of 3 x 10$^{16}$ atoms/cm$^3$, and thus is an intrinsic semiconductor. Where the thickness of the undoped amorphous silicon layer 26 is 1000 nm (i.e. 1 $\mu$m), the boron-doped amorphous silicon layer 27 is not formed, and where the thickness of the latter layer 27 is 1000 nm, the former layer 26 is not formed.

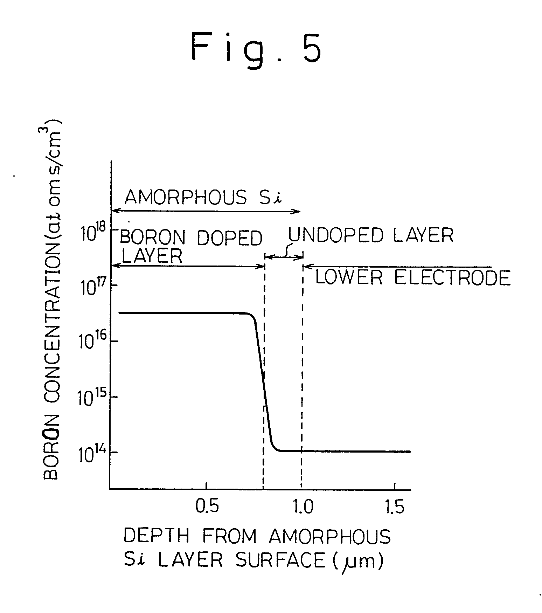

Where an undoped amorphous silicon layer 200 nm in thickness, and a boron-doped amorphous silicon layer 800 nm in thickness, are formed on the lower electrode 23, the boron concentration (content) distribution profile becomes as shown in Fig. 5, and there is no pile-up of boron near the lower electrode. Note, Fig. 5 shows that the lower electrode contains 1 x 10$^{14}$ atoms/cm$^3$, but this value is the lower limit of a measuring instrument; the lower electrode does not substantially contain boron dopant.

After the deposition of the boron-doped amorphous silicon layer 27, a CH gas (20 SCCM) and a H$_2$ gas (20 SCCM) containing a B$_2$H$_6$ gas (1%) are additionally fed into the same CVD apparatus and a plasma CVD process is performed under the above-mentioned conditions in an atmosphere of a mixed gas of SiH$_4$ (10 SCCM), CH$_4$, B$_2$H$_6$ and H$_2$ (80 SCCM) gases. As a result, the p-type SiC amorphous layer 28 having a thickness of 30 nm is successively deposited on the layer 27.

The SiC layer 28 forms a hetero-junction barrier to prevent an injection of electrons from the transparent electrode layer 29 made of ITO, which improves the photodiode properties. The SiC layer 28 prevents a reaction of the amorphous silicon layer 27 with the ITO layer 29. Note, since the SiC layer 28 should not absorb incident light, the thickness thereof is relatively thin.

Finally, the ITO transparent electrode layer 29 having a thickness of 150 nm is deposited (formed) on the whole surface of the p-type amorphous SiC layer 28 by a sputtering method. The combination of the transparent electrode layer 29 with the SiC layer 28 is regarded as an upper electrode, and thus the amorphous photodiode shown in Fig. 4 is obtained.

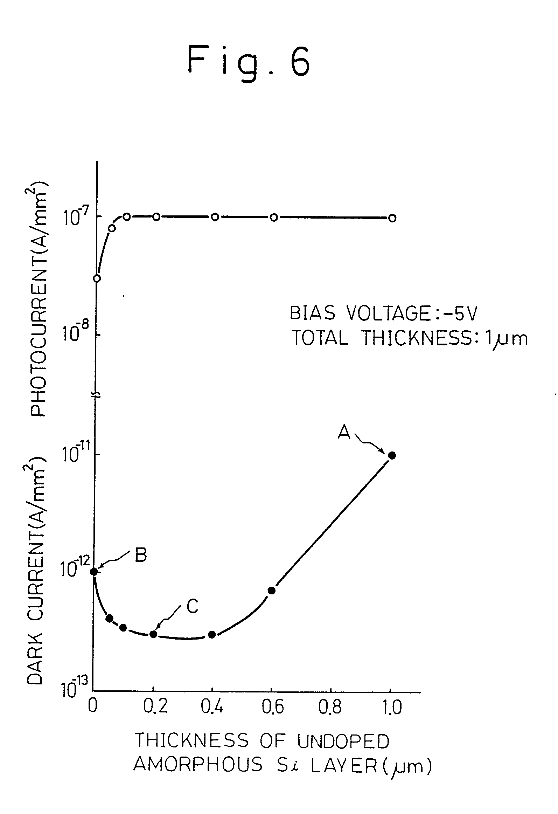

To determine the respective thicknesses of the doped and undoped amorphous silicon layers which provide the best results, a number of photodiodes, with layers of various thicknesses, were tested. A bias voltage was applied to each of the amorphous photodiodes (e.g., the ITO electrode 29 has a potential of -5 V and the aluminum electrode 23 is grounded), so that a dark current of the photodiode could be measured. The measured dark currents are shown in Fig. 6, plotted against the thickness of the undoped amorphous silicon layer. Next, a green light of $150 \ell x$ was made incident on each of the photodiodes biased under the above-mentioned conditions, and a photocurrent due to the generated electron-hole pairs was measured. The measured photocurrents are shown in Fig. 6, plotted against the thickness of the undoped amorphous silicon layer.

As can be seen from Fig. 6, the dark current is reduced when the thickness of the undoped amorphous silicon layer is in the range from 50 to 500 nm, and, in particular, has an even smaller value when in the range from 200 to 400 nm. Where the undoped amorphous silicon layer has a thickness of less than 50 nm, the photocurrent is reduced, and if the thickness is more than 500 nm, the dark current is increased.

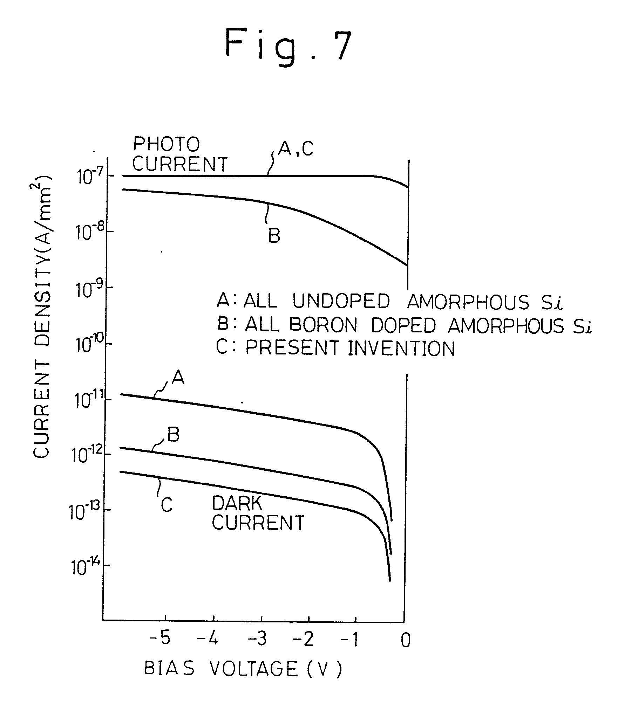

Among the various obtained amorphous photodiodes the following three photodiodes A, B and C (see Figs. 6 and 7) were tested to measure the dark currents and photocurrents thereof by using a bias voltage parameter. Fig. 7 illustrates the relationship between current density and bias voltage in respect of the dark currents and the photocurrents.

Photodiode A was provided with only the undoped amorphous silicon layer and not the boron-doped amorphous silicon layer;

Photodiode B was provided with only the boron-doped amorphous silicon layer and not the undoped amorphous silicon layer; and

Photodiode C, according to an embodiment of the present invention, was provided with the undoped amorphous silicon layer (200 nm in thickness) and the boron-doped amorphous silicon layer (800 nm in thickness) formed on the former layer.

As can be seen from Fig. 7, the dark current was reduced by boron-doping, and further reduced by adding the undoped amorphous silicon layer between the boron-doped amorphous intrinsic silicon layer and the lower electrode in accordance with an embodiment of the present invention. The photocurrent was also reduced by boron-doping; namely, the photocurrent of photodiode B was smaller than that of photodiode A. As the bias voltage became smaller, the photocurrent of the photodiode B was further reduced. However, the photocurrent of the photodiode C, embodying the present invention, was the same as that of the photodiode A. Thus, it can be seen that the addition of the undoped amorphous silicon layer eliminates the adverse influence of the boron dopant on the photocurrent.

Example 2

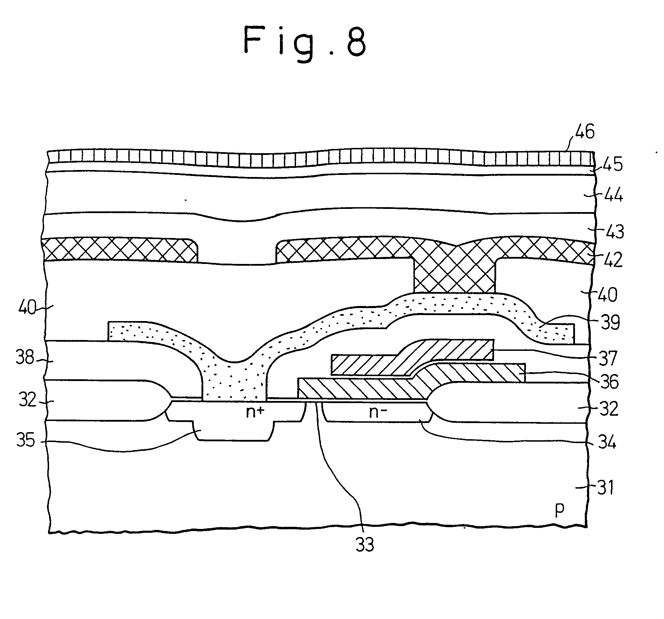

Referring to Fig. 8, an amorphous photodiode according to a second embodiment of the present invention was used in a CCD image sensor.

In this case, the CCD image sensor had a conventional basic structure, and comprised a p-type silicon single crystal substrate 31, a thick oxide ($SiO_2$) layer 32, a thin oxide ($SiO_2$) layer 33, an $n^-$-type region 34 of a vertical CCD, an $n^+$-type region 35 of a storage diode, a first polycrystalline silicon layer 36, a second polycrystalline silicon layer 37, an insulating ($SiO_2$ or PSG) layer 38, a wiring layer (Al patterned layer) 39, a flattening insulator layer 40, and an amorphous photodiode embodying the present invention. The photodiode comprised a lower (pixel) electrode 42 consisting of an aluminum layer and a TiN barrier layer, an undoped amorphous silicon layer 43, a boron-doped amorphous intrinsic silicon layer 44, a p-type amorphous SiC layer 45, and a transparent upper electrode layer (ITO electrode) 46.

When light was incident on the CCD image sensor, the light was absorbed and generated electron-hole pairs in the boron-doped amorphous silicon layer 44. Since a potential of +V was applied to the lower electrode 42 and the ITO electrode 46 was grounded, the holes were collected at the ITO electrode 46, and the electrons were collected at the lower electrode 42, flowed through the wiring layer 39, and were stored in the storage diode 35. Then the stored electrons (electric charge signal) were transferred to the vertical CCD 34. By employing an amorphous photodiode embodying the present invention, the dark current was reduced, thereby lowering the noise and allowing a satisfactory photocurrent to be obtained. Thus, the properties of the CCD image sensor were improved.

It will be obvious that the scope of the present invention is not restricted to the above-mentioned embodiments and that many variations are possible for persons skilled in the art without departing from the scope of the invention. For example, although the boron dose (concentration) in the boron-doped amorphous silicon layer is constant in the above-mentioned embodiments, it is possible to incline the boron concentration distribution profile by gradually increasing the $B_2H_6$ gas to a predetermined value during the doping of the amorphous silicon layer.

Thus, an embodiment of the present invention can desirably provide an amorphous photodiode structure comprising a boron-doped amorphous intrinsic silicon layer, in which an increase of recombination centers is prevented, and an adherence is improved.

Such an embodiment of the present invention can desirably provide an amorphous photodiode in which a reduction of the photocurrent is avoided and a dark current is reduced.

## Claims

1. A photosemiconductor device of the type in which light reaching a photosensitive layer (14;27;44) of a doped amorphous semiconductor material, between two electrodes (12;15;23,29;42,46) of the device, generates electron-hole pairs in that layer (14;27;44), the doping of the said amorphous semiconductor material being such that its conductivity is substantially equal to that of the purely intrinsic form of that material;
characterised by a layer (13;26;43) of non-doped amorphous semiconductor material interposed between the said photosensitive layer (14;27;44) and one of the said electrodes (12;23;42).

2. A device as claimed in claim 1 or 2, wherein the said photosensitive layer (14;27;44) is doped with an acceptor.

3. A device as claimed in claim 1 or 2, wherein the said photosensitive layer (14;27;44) is doped with boron.

4. A photosemiconductor device comprising an amorphous intrinsic semiconductor layer which is doped with boron at a dose by which the semiconductor is made intrinsic and in which layer electron-hole pairs are generated by an incident light, and two electrodes holding said semiconductor layer therebetween are supplied with a bias voltage for taking out the generated electric charges, one being an electrode for collecting electrons and the other being an electrode for collecting holes, characterized in that an amorphous semiconductor layer not doped with a dopant is formed between said electron collecting electrode and said amorphous intrinsic semiconductor layer.

5. A photosemiconductor device according to claim 4 wherein said electron collecting electrode is a lower electrode formed on an insulating layer, and said hole collection electrode is an upper electrode formed on said amorphous intrinsic semiconductor layer.

6. A photosemiconductor device according to claim 5, wherein said lower electrode is a conductive layer made of a material selected from the group consisting of aluminum, tungsten and polycrystalline silicon.

7. A photosemiconductor device according to claim 5 or 6, wherein said lower electrode consists of an aluminum conductive layer and a barrier layer formed between said aluminum conductive layer and said undoped amorphous semiconductor layer.

8. A photosemiconductor device according to claim 5, 6 or 7, wherein said upper electrode is a transparent electrode.

9 . A photosemiconductor device according to claim 8, wherein said transparent electrode is made of indium-tin-oxide (ITO).

10. A photosemiconductor device according to claim 8 or 9, wherein said upper electrode comprises a p-type amorphous SiC layer between said transparent electrode and said amorphous intrinsic semiconductor layer.

11. A photosemiconductor device according to any one of claims 4 to 10, wherein said undoped amorphous semiconductor layer is amorphous silicon.

12. A photosemiconductor device according to claim 11, wherein said undoped amorphous semiconductor layer has a thickness of from 50 to 500 nm.

13. A photosemiconductor device according to claim 12, wherein said undoped amorphous semiconductor layer has a thickness of from 200 to 400 nm.

14. A photosemiconductor device according to any one of claims 4 to 13, wherein said amorphous intrinsic semiconductor layer is amorphous silicon having a boron content of from 0.05 to 5 ppm.

15. A photosemiconductor device according to claim 14, wherein a total thickness of said amorphous intrinsic silicon layer and said undoped amorphous silicon layer is from 1 to 3 $\mu$m.

# Fig.1 (PRIOR ART)

# Fig.2 (PRIOR ART)

# Fig.3

# Fig.4

EP 0 388 154 A2

# Fig. 5

# Fig. 6

EP 0 388 154 A2

# Fig. 7

A: ALL UNDOPED AMORPHOUS S$i$
B: ALL BORON DOPED AMORPHOUS S$i$
C: PRESENT INVENTION

# Fig.8